# EUROPEAN PATENT APPLICATION

(11) **EP 4 432 333 A2**
(43) Date of publication of application: **18.09.2024**
(21) Application number: 23187881.0
(22) Date of filing: 26.07.2023
(51) Int. Cl.: H01L 21/50, H01L 23/24, H01L 23/31, H01L 23/00

(54) **SEMICONDUCTOR DEVICE**

(30) Priority: 17.03.2023 JP 2023043638
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: IGUCHI, Tomohiro, Tokyo (JP); HIRAKAWA, Tatsuya, Tokyo (JP); MINAMI, Shogo, Tokyo (JP); MATSUO, Hiroyuki, Tokyo (JP); KOMATSU, Izuru, Tokyo (JP)
(74) Representative: Kramer Barske Schmidtchen Patentanwälte PartG mbB

(57) **Abstract**

A semiconductor device according to an embodiment includes: an insulating substrate having a first metal layer and a second metal layer; a semiconductor chip on the first metal layer having an upper electrode and a lower electrode connected to the first metal layer; a bonding wire having a first end portion connected to the upper electrode and a second end portion connected to the second metal layer; a first resin layer covering the semiconductor chip and the bonding wire, the first resin layer containing a first resin; a second resin layer covering a bonding portion between the first end portion and the upper electrode containing a second resin having a Young's modulus higher than that of the first resin; a third resin layer on the first resin layer, the third resin layer containing a third resin having a moisture permeability lower than that of the first resin.

## Description

### CROSS-REFERENCE TO RELATED APPLICATION

This application is based upon and claims the benefit of priority from Japanese Patent Application No. 2023-043638, filed on March 17, 2023, the entire contents of which are incorporated herein by reference.

### FIELD

Embodiments described herein relate generally to a semiconductor device.

### BACKGROUND

In a power semiconductor module, for example, a power semiconductor chip is mounted on a base plate with an insulating substrate interposed therebetween. The power semiconductor chip is, for example, a metal oxide field effect transistor (MOSFET), an insulated gate bipolar transistor (IGBT), or a diode.

For example, a temperature change of the power semiconductor chip is repeated by repeating an ON operation and an OFF operation of the power semiconductor module. By repeating the temperature change, for example, a bonding portion (interface) between a semiconductor chip and a bonding wire may be peeled off by thermal stress, which may result in a connection failure. Therefore, even when the temperature change of the power semiconductor chip is repeated, it is required to suppress peeling of the bonding portion between the semiconductor chip and the bonding wire and to achieve high reliability of the power semiconductor module.

### BRIEF DESCRIPTION OF THE DRAWINGS

FIGS. 1A and 1B are schematic diagrams of a semiconductor device according to a first embodiment;
FIG. 2 is an enlarged schematic cross-sectional view of the semiconductor device according to the first embodiment;
FIG. 3 is an enlarged schematic cross-sectional view of a semiconductor device according to a modification of the first embodiment;
FIG. 4 is a schematic cross-sectional view of a semiconductor device according to a second embodiment;
FIG. 5 is an enlarged schematic cross-sectional view of the semiconductor device according to the second embodiment;
FIG. 6 is a schematic cross-sectional view of a semiconductor device according to a modification of the second embodiment;
FIG. 7 is a schematic cross-sectional view of a semiconductor device according to a third embodiment;
FIG. 8 is an enlarged schematic cross-sectional view of the semiconductor device according to the third embodiment;
FIG. 9 is a schematic cross-sectional view of a semiconductor device according to a modification of the third embodiment; and
FIG. 10 is an enlarged schematic cross-sectional view of the semiconductor device according to the modification of the third embodiment.

### DETAILED DESCRIPTION

A semiconductor device according to one aspect of the present disclosure includes: a base plate; an insulating substrate provided on the base plate, the insulating substrate having a first metal layer and a second metal layer on a surface thereof; a semiconductor chip provided on the first metal layer, the semiconductor chip including an upper electrode, a lower electrode connected to the first metal layer, and a semiconductor layer provided between the upper electrode and the lower electrode; a bonding wire having a first end portion and a second end portion, the first end portion being connected to the upper electrode, and the second end portion being connected to the second metal layer; a first resin layer configured to cover the insulating substrate, the semiconductor chip, and the bonding wire, the first resin layer containing a first resin; a second resin layer configured to cover at least a part of a bonding portion between the first end portion and the upper electrode, the second resin layer containing a second resin having a Young's modulus higher than a Young's modulus of the first resin; a third resin layer provided on the first resin layer so as to be in contact with the first resin layer, the third resin layer containing a third resin having a moisture permeability lower than a moisture permeability of the first resin; and a frame body configured to surround the insulating substrate, the first resin layer, and the third resin layer.

In the present specification, the same or similar members will be denoted by the same reference numerals, and redundant description may be omitted.

In the present specification, in order to indicate a positional relationship between components and the like, an upward direction in the drawings may be described as "upper", and a downward direction in the drawings may be described as "lower". In the present specification, the concepts of "upper" and "lower" are not necessarily terms indicating a relationship with the direction of gravity.

A type of resin constituting a semiconductor device of an embodiment can be specified by, for example, a Fourier transform infrared spectroscopy method (FT-IR method) or a pyrolysis-gas chromatography/mass spectrometry method. Physical property values such as "Young's modulus", "moisture permeability", and "elongation rate" of a resin forming the semiconductor device of the embodiment can be specified by specifying the type of resin.

### (First Embodiment)

A semiconductor device according to a first embodiment includes: a base plate; an insulating substrate provided on the base plate, the insulating substrate having a first metal layer and a second metal layer on a surface thereof; a semiconductor chip provided on the first metal layer, the semiconductor chip including an upper electrode, a lower electrode connected to the first metal layer, and a semiconductor layer provided between the upper electrode and the lower electrode; a bonding wire having a first end portion and a second end portion, the first end portion being connected to the upper electrode, and the second end portion being connected to the second metal layer; a first resin layer configured to cover the insulating substrate, the semiconductor chip, and the bonding wire, the first resin layer containing a first resin; a second resin layer configured to cover at least a part of a bonding portion between the first end portion and the upper electrode, the second resin layer containing a second resin having a Young's modulus higher than a Young's modulus of the first resin; a third resin layer provided on the first resin layer so as to be in contact with the first resin layer, the third resin layer containing a third resin having a moisture permeability lower than a moisture permeability of the first resin; and a frame body configured to surround the insulating substrate, the first resin layer, and the third resin layer.

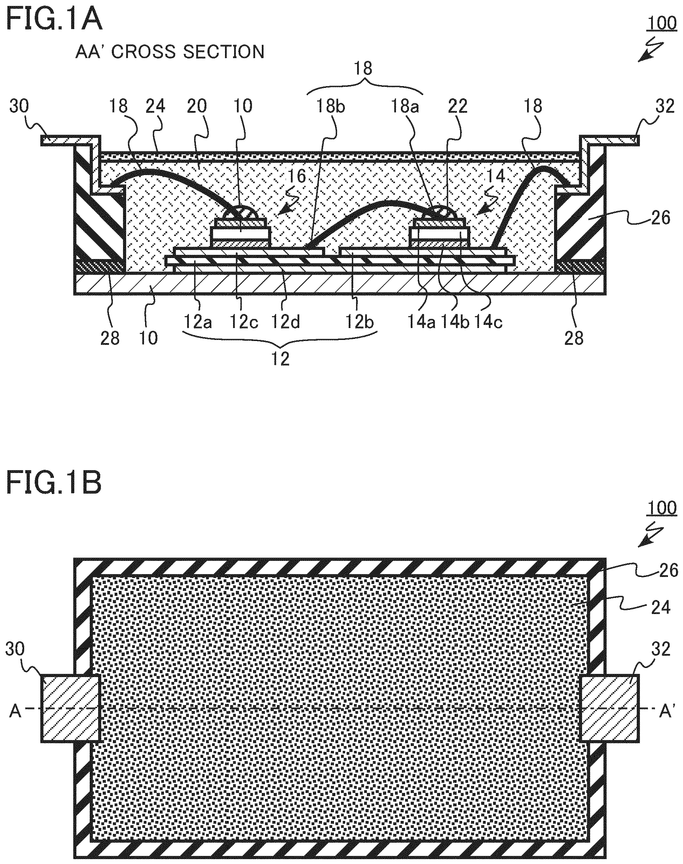

FIGS. 1A and 1B are schematic diagrams of the semiconductor device according to the first embodiment. FIG. 1A is a cross-sectional view. FIG. 1B is a top view. FIG. 1A is an A-A' cross section of FIG. 1B.

The semiconductor device according to the first embodiment is a power semiconductor module 100. As illustrated in FIG. 1A, in the power semiconductor module 100 according to the first embodiment, two MOSFETs are connected in series. The power semiconductor module 100 according to the first embodiment is a so-called "2 in 1" type module in which a half bridge circuit can be configured by one module. For example, a three-phase inverter circuit can be configured by using three power semiconductor modules 100 according to the first embodiment.

The power semiconductor module 100 includes a base plate 10, an insulating substrate 12, a first MOSFET 14, a second MOSFET 16, a bonding wire 18, a sealing layer 20, a wire fixing layer 22, a first moisture-proof layer 24, a resin case 26, an adhesive layer 28, a first power terminal 30, and a second power terminal 32. The insulating substrate 12 includes a ceramic layer 12a, a first surface metal layer 12b, a second surface metal layer 12c, and a back surface metal layer 12d. The first MOSFET 14 includes an upper electrode 14a, a lower electrode 14b, and a semiconductor layer 14c. The bonding wire 18 has a first end portion 18a and a second end portion 18b.

The first surface metal layer 12b is an example of a first metal layer. The second surface metal layer 12c is an example of a second metal layer. The first MOSFET 14 is an example of a semiconductor chip. The sealing layer 20 is an example of a first resin layer. The wire fixing layer 22 is an example of a second resin layer. The first moisture-proof layer 24 is an example of a third resin layer. The resin case 26 is an example of a frame body. The adhesive layer 28 is an example of a fourth resin layer.

It is noted that the power semiconductor module 100 includes an AC terminal and a gate terminal (not illustrated). In addition, the power semiconductor module 100 may include a resin lid (not illustrated) on the first moisture-proof layer 24.

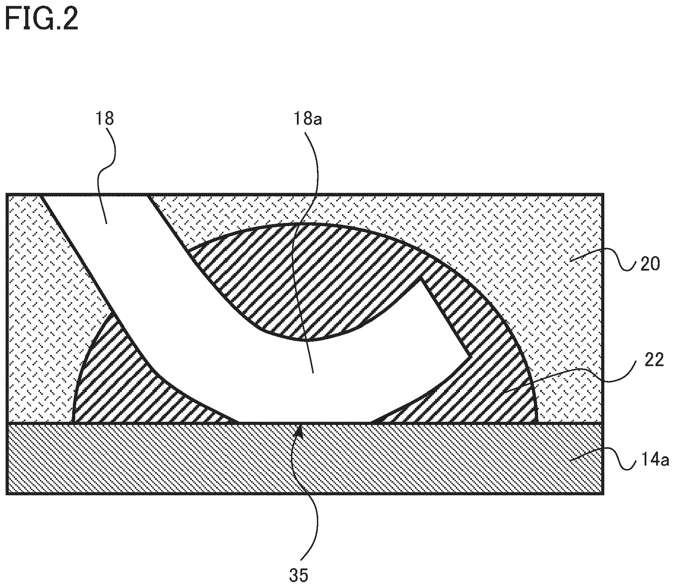

FIG. 2 is an enlarged schematic cross-sectional view of the semiconductor device according to the first embodiment. FIG. 2 is an enlarged view including a bonding portion 35 (interface) between the first end portion 18a of the bonding wire 18 and the upper electrode 14a.

The base plate 10 is provided below the power semiconductor module 100.

The base plate 10 is, for example, metal. The base plate 10 is, for example, copper. For example, when the power semiconductor module 100 is mounted on a product, a heat sink (not illustrated) is connected to the back surface of the base plate 10.

The insulating substrate 12 is provided on the base plate 10. The insulating substrate 12 is provided between the base plate 10 and the first MOSFET 14 and between the base plate 10 and the second MOSFET 16. The insulating substrate 12 has a function of electrically separating the base plate 10 from the first MOSFET 14 and the second MOSFET 16.

The insulating substrate 12 includes a ceramic layer 12a, a first surface metal layer 12b, a second surface metal layer 12c, and a back surface metal layer 12d. The ceramic layer 12a is provided between the first surface metal layer 12b and the back surface metal layer 12d and between the second surface metal layer 12c and the back surface metal layer 12d.

The ceramic layer 12a is, for example, aluminum oxide, aluminum nitride, or silicon nitride. The first surface metal layer 12b, the second surface metal layer 12c, and the back surface metal layer 12d are, for example, copper.

The first MOSFET 14 is provided on the first surface metal layer 12b. The first MOSFET 14 is an example of a semiconductor chip.

The first MOSFET 14 includes an upper electrode 14a, a lower electrode 14b, and a semiconductor layer 14c. The semiconductor layer 14c is provided between the upper electrode 14a and the lower electrode 14b.

The upper electrode 14a functions as, for example, a source electrode. The lower electrode 14b functions as, for example, a drain electrode. The first MOSFET 14 includes, for example, a gate electrode (not illustrated).

The upper electrode 14a and the lower electrode 14b are metal. The upper electrode 14a and the lower electrode 14b are, for example, aluminum.

The semiconductor layer 14c is, for example, silicon carbide or silicon.

The lower electrode 14b of the first MOSFET 14 is connected to the first surface metal layer 12b. The lower electrode 14b of the first MOSFET 14 is electrically connected to the first surface metal layer 12b.

The second MOSFET 16 is provided on the second surface metal layer 12c. The second MOSFET 16 includes an upper electrode, a lower electrode, and a semiconductor layer.

The lower electrode of the second MOSFET 16 is connected to the second surface metal layer 12c. The lower electrode of the second MOSFET 16 is electrically connected to the second surface metal layer 12c.

The bonding wire 18 has a function of electrically connecting a conductor in the power semiconductor module 100. The material of the bonding wire 18 is, for example, aluminum, copper, or gold.

The bonding wire 18 electrically connects, for example, the upper electrode 14a of the first MOSFET 14 to the second surface metal layer 12c. The bonding wire 18 has, for example, the first end portion 18a and the second end portion 18b. The first end portion 18a is connected to the upper electrode 14a of the first MOSFET 14. The second end portion 18b is connected to the second surface metal layer 12c.

The first end portion 18a is connected to the upper electrode 14a of the first MOSFET 14 at the bonding portion 35. The first end portion 18a is in contact with the upper electrode 14a at the bonding portion 35.

The bonding wire 18 electrically connects, for example, the first power terminal 30 to the upper electrode of the second MOSFET 16. Further, the bonding wire 18 electrically connects, for example, the first surface metal layer 12b to the second power terminal 32.

The sealing layer 20 covers the insulating substrate 12, the first MOSFET 14, the second MOSFET 16, and the bonding wire 18. The sealing layer 20 is an example of a first resin layer. The sealing layer 20 is surrounded by the resin case 26.

The sealing layer 20 has a function of protecting the insulating substrate 12, the first MOSFET 14, the second MOSFET 16, and the bonding wire 18. In addition, the sealing layer 20 has a function of electrically insulating the insulating substrate 12, the first MOSFET 14, the second MOSFET 16, and the bonding wire 18.

The sealing layer 20 contains a sealing resin. The sealing resin is an example of a first resin. The sealing layer 20 is formed of, for example, a sealing resin. The sealing resin is, for example, a silicone gel.

As illustrated in FIG. 2, the wire fixing layer 22 covers at least a part of the bonding portion 35 between the first end portion 18a of the bonding wire 18 and the upper electrode 14a of the first MOSFET 14. The wire fixing layer 22 is an example of a second resin layer. In the case of FIG. 2, the wire fixing layer 22 covers the entire first end portion 18a.

The wire fixing layer 22 is covered with the sealing layer 20. The wire fixing layer 22 is in contact with the upper electrode 14a, the bonding wire 18, and the sealing layer 20.

The wire fixing layer 22 covers, for example, the entire periphery of the outer edge portion of the bonding portion 35. For example, the wire fixing layer 22 may cover only a part of the outer edge portion of the bonding portion 35.

The wire fixing layer 22 has a function of suppressing peeling of the bonding portion 35 due to thermal stress.

The wire fixing layer 22 contains a high Young's modulus resin. The high Young's modulus resin is an example of a second resin. The wire fixing layer 22 is formed of, for example, the high Young's modulus resin. The high Young's modulus resin has a Young's modulus higher than a Young's modulus of the sealing resin contained in the sealing layer 20. The Young's modulus of the high Young's modulus resin is, for example, equal to or more than 1000 MPa and equal to or less than 100 GPa.

A glass transition temperature of the high Young's modulus resin is, for example, equal to or more than 250°C and equal to or less than 400°C. A linear expansion coefficient of the high Young's modulus resin is, for example, equal to or more than 10 × 10⁻⁶/°C and equal to or less than 50 × 10⁻⁶/°C.

The high Young's modulus resin is, for example, polyamide-imide, polyimide, or polyimide silicone.

The high Young's modulus resin can be formed by using, for example, a jet dispenser method, an air dispenser method, or a spray coating method.

The first moisture-proof layer 24 is provided on the sealing layer 20. The first moisture-proof layer 24 is provided in contact with the sealing layer 20. The first moisture-proof layer 24 is an example of a third resin layer.

As shown in FIG. 1B, the first moisture-proof layer 24 is surrounded by the resin case 26. The outer peripheral portion of the first moisture-proof layer 24 is in contact with, for example, the resin case 26.

The first moisture-proof layer 24 has a function of suppressing entry of moisture from the outside of the power semiconductor module 100.

The first moisture-proof layer 24 includes a first low-moisture-permeable resin. The first low-moisture-permeable resin is an example of a third resin. The first moisture-proof layer 24 is formed of, for example, the first low-moisture-permeable resin. The first low-moisture-permeable resin has a moisture permeability lower than a moisture permeability of the sealing resin contained in the sealing layer 20.

The first low-moisture-permeable resin has, for example, an elongation rate equal to or more than an elongation rate of the sealing resin contained in the sealing layer 20. The elongation rate is a maximum deformation amount immediately before a material is broken, and the elongation rate is represented by a ratio to the length of a material before deformation.

The first low-moisture-permeable resin is, for example, synthetic rubber, a polyophyllene resin, para-xylene, or polyvinyl alcohol (PVA).

The resin case 26 surrounds the insulating substrate 12, the sealing layer 20, and the first moisture-proof layer 24. The resin case 26 is an example of a frame body. The resin case 26 is provided on the base plate 10.

The resin case 26 has a function of protecting the first MOSFET 14, the second MOSFET 16, and the insulating substrate 12.

The adhesive layer 28 is provided between the base plate 10 and the resin case 26. The adhesive layer 28 is an example of a fourth resin layer. The adhesive layer 28 has a function of bonding and fixing the base plate 10 and the resin case 26.

The adhesive layer 28 is provided on, for example, the base plate 10 so as to surround the insulating substrate 12.

The adhesive layer 28 contains an adhesive resin. The adhesive resin is an example of a fourth resin. The adhesive layer 28 is formed of, for example, the adhesive resin. The adhesive resin is, for example, a silicone resin.

The first power terminal 30 and the second power terminal 32 are provided on the resin case 26. For example, a negative voltage is applied to the first power terminal 30. For example, a positive voltage is applied to the second power terminal 32.

Next, functions and effects of the semiconductor device according to the first embodiment will be described.

For example, a temperature change of the power semiconductor chip is repeated by repeating an ON operation and an OFF operation of the power semiconductor module. As the temperature change is repeated, for example, a bonding portion (interface) between a semiconductor chip and a bonding wire may be peeled off by thermal stress, which may result in an open failure (connection failure). Therefore, even when the temperature change of the power semiconductor chip is repeated, it is required to suppress peeling of the bonding portion between the semiconductor chip and the bonding wire and to achieve high reliability of the power semiconductor module. In other words, even when the temperature change of the power semiconductor chip is repeated, it is required to suppress a connection failure of the wiring and to achieve high reliability of the power semiconductor module.

The power semiconductor module 100 according to the first embodiment includes the wire fixing layer 22 that covers at least a part of the bonding portion 35 between the first end portion 18a of the bonding wire 18 and the upper electrode 14a of the first MOSFET 14. The high Young's modulus resin contained in the wire fixing layer 22 has a Young's modulus higher than a Young's modulus of the sealing resin contained in the sealing layer 20.

By providing the wire fixing layer 22 having a high Young's modulus, even when thermal stress is applied to the bonding portion 35, a relative movement between the first end portion 18a and the upper electrode 14a is suppressed. Therefore, peeling of the bonding portion 35 between the first end portion 18a and the upper electrode 14a is suppressed. Therefore, an open failure in the bonding portion 35 is suppressed, thereby making it possible to implement the power semiconductor module 100 having high reliability.

The Young's modulus of the high Young's modulus resin contained in the wire fixing layer 22 is preferably equal to or more than 1000 MPa. When the Young's modulus is equal to or more than 1000 MPa, peeling of the bonding portion 35 is further suppressed.

The glass transition temperature of the high Young's modulus resin contained in the wire fixing layer 22 is preferably, for example, equal to or more than 250°C. When the glass transition temperature is equal to or more than 250°C, peeling of the bonding portion 35 at a high temperature is further suppressed.

The linear expansion coefficient of the high Young's modulus resin contained in the wire fixing layer 22 is preferably equal to or more than 10 × 10⁻⁶/°C and equal to or less than 50 × 10⁻⁶/°C. In a case where the linear expansion coefficient is equal to or more than 10 × 10⁻⁶/°C and equal to or less than 50 × 10⁻⁶/°C, for example, when the material of the bonding wire 18 is aluminum, the linear expansion coefficient of the high Young's modulus resin is equivalent to the linear expansion coefficient of aluminum. Therefore, thermal stress is suppressed, and peeling of the bonding portion 35 is further suppressed.

As described above, the power semiconductor module 100 according to the first embodiment includes the wire fixing layer 22, thereby making it possible to suppress peeling of the bonding portion 35. On the other hand, there is a concern that moisture easily enters an interface between the wire fixing layer 22 and the sealing layer 20.

When moisture enters the interface between the wire fixing layer 22 and the sealing layer 20, for example, a short circuit failure may occur between the upper electrode 14a and the lower electrode 14b of the first MOSFET 14. When the short circuit failure occurs, the reliability of the power semiconductor module 100 deteriorates.

The power semiconductor module 100 according to the first embodiment includes the first moisture-proof layer 24 on the sealing layer 20. The first low-moisture-permeable resin contained in the first moisture-proof layer 24 has a moisture permeability lower than a moisture permeability of the sealing resin contained in the sealing layer 20.

The first moisture-proof layer 24 having a low moisture permeability is provided on the sealing layer 20, thereby making it possible to suppress entry of moisture into the interface between the wire fixing layer 22 and the sealing layer 20. Therefore, for example, occurrence of a short circuit failure of the first MOSFET 14 is suppressed.

The first low-moisture-permeable resin contained in the first moisture-proof layer 24 preferably has an elongation rate equal to or more than an elongation rate of the sealing resin contained in the sealing layer 20. Since the first moisture-proof layer 24 has a high elongation rate, the first moisture-proof layer 24 can follow the deformation of the sealing layer 20. Therefore, for example, cracking of the first moisture-proof layer 24 due to deformation of the sealing layer 20 is suppressed.

### (Modification)

A semiconductor device according to a modification of the first embodiment is different from the semiconductor device according to the first embodiment in that a second resin layer fills only a space between a first end portion of a bonding wire and an upper electrode of a semiconductor chip.

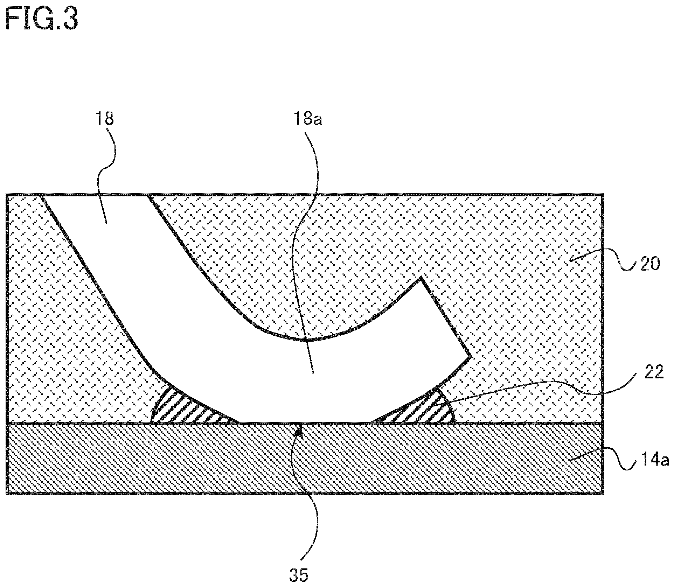

FIG. 3 is an enlarged schematic cross-sectional view of the semiconductor device according to the modification of the first embodiment. FIG. 3 is a diagram corresponding to FIG. 2 of the first embodiment.

As illustrated in FIG. 3, a wire fixing layer 22 of a semiconductor module according to the modification of the first embodiment is provided so as to fill a space between a first end portion 18a of a bonding wire 18 and an upper electrode 14a of a first MOSFET 14. The wire fixing layer 22 is not provided above the first end portion 18a.

In the semiconductor module according to the modification of the first embodiment as well, since the wire fixing layer 22 covers at least a part of a bonding portion 35, functions and effects similar to those of the power semiconductor module 100 according to the first embodiment are achieved.

As described above, according to the first embodiment and the modification, it is possible to implement a semiconductor device capable of suppressing a connection failure of wiring and having high reliability.

### (Second Embodiment)

A semiconductor device according to a second embodiment is different from the semiconductor device according to the first embodiment in further including a fifth resin layer provided between a first resin layer and a fourth resin layer, the fifth resin layer containing a fifth resin having a moisture permeability lower than a moisture permeability of a first resin and a moisture permeability of a fourth resin. Hereinafter, some descriptions of contents overlapping with the first embodiment may be omitted.

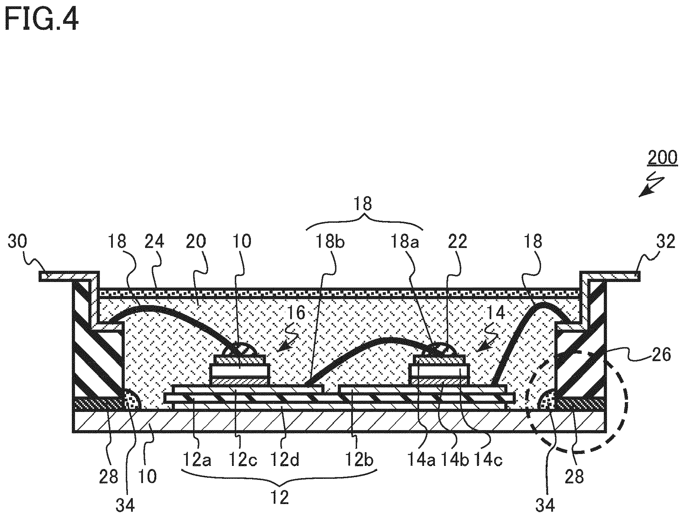

FIG. 4 is a schematic cross-sectional view of the semiconductor device according to the second embodiment. FIG. 4 is a diagram corresponding to FIG. 1A of the first embodiment.

The semiconductor device according to the second embodiment is a power semiconductor module 200.

The power semiconductor module 200 includes a base plate 10, an insulating substrate 12, a first MOSFET 14, a second MOSFET 16, a bonding wire 18, a sealing layer 20, a wire fixing layer 22, a first moisture-proof layer 24, a resin case 26, an adhesive layer 28, a first power terminal 30, a second power terminal 32, and a second moisture-proof layer 34. The insulating substrate 12 includes a ceramic layer 12a, a first surface metal layer 12b, a second surface metal layer 12c, and a back surface metal layer 12d. The first MOSFET 14 includes an upper electrode 14a, a lower electrode 14b, and a semiconductor layer 14c. The bonding wire 18 has a first end portion 18a and a second end portion 18b.

The first surface metal layer 12b is an example of a first metal layer. The second surface metal layer 12c is an example of a second metal layer. The first MOSFET 14 is an example of a semiconductor chip. The sealing layer 20 is an example of a first resin layer. The wire fixing layer 22 is an example of a second resin layer. The first moisture-proof layer 24 is an example of a third resin layer. The resin case 26 is an example of a frame body. The adhesive layer 28 is an example of a fourth resin layer. The second moisture-proof layer 34 is an example of a fifth resin layer.

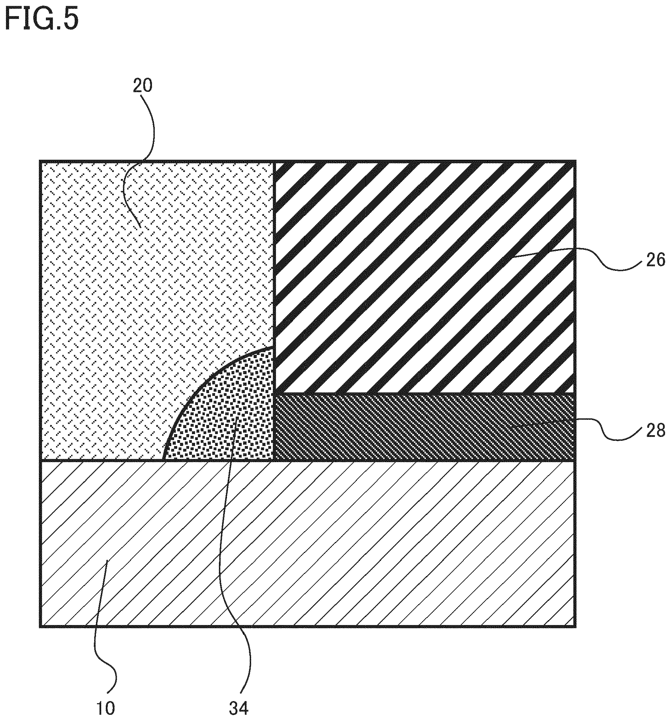

FIG. 5 is an enlarged schematic cross-sectional view of the semiconductor device according to the second embodiment. FIG. 5 is an enlarged view of a portion surrounded by a dotted line in FIG. 4. FIG. 5 is an enlarged view including the second moisture-proof layer 34.

The second moisture-proof layer 34 is provided between the sealing layer 20 and the adhesive layer 28. The second moisture-proof layer 34 is an example of a fifth resin layer.

The second moisture-proof layer 34 is in contact with the sealing layer 20 and the adhesive layer 28. The second moisture-proof layer 34 is in contact with, for example, the base plate 10 and the resin case 26.

The second moisture-proof layer 34 is provided, for example, along a corner between the base plate 10 and the resin case 26. The second moisture-proof layer 34 has, for example, an annular shape.

The second moisture-proof layer 34 has a function of suppressing entry of moisture from the outside of the power semiconductor module 200. The second moisture-proof layer 34 has a function of suppressing entry of moisture through the adhesive layer 28 between the base plate 10 and the resin case 26.

The second moisture-proof layer 34 includes a second low-moisture-permeable resin. The second low-moisture-permeable resin is an example of a fifth resin. The second moisture-proof layer 34 is formed of, for example, the second low-moisture-permeable resin. The second low-moisture-permeable resin has a moisture permeability lower than a moisture permeability of a sealing resin contained in the sealing layer 20 and a moisture permeability of an adhesive resin contained in the adhesive layer 28.

The second low-moisture-permeable resin is, for example, synthetic rubber, a polyophyllene resin, para-xylene, or polyvinyl alcohol (PVA).

The second low-moisture-permeable resin may be the same material as or a different material from the first low-moisture-permeable resin.

With the power semiconductor module 200 of the second embodiment, entry of moisture into an interface between the wire fixing layer 22 and the sealing layer 20 can be further suppressed. Therefore, for example, occurrence of a short circuit failure of the first MOSFET 14 is suppressed.

### (Modification)

A semiconductor device according to a modification of the second embodiment is different from the semiconductor device according to the second embodiment in that a fifth resin layer is provided between a frame body and a first resin layer, and the fifth resin layer covers at least a part of an insulating substrate.

The semiconductor device according to the modification of the second embodiment is a power semiconductor module 201.

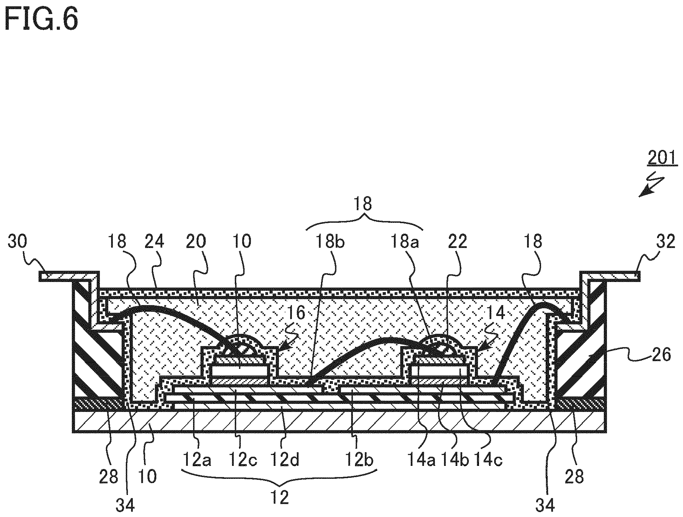

FIG. 6 is a schematic cross-sectional view of the semiconductor device according to the modification of the second embodiment. FIG. 6 is a diagram corresponding to FIG. 4 of the second embodiment.

A second moisture-proof layer 34 of the power semiconductor module 201 is provided between a sealing layer 20 and an adhesive layer 28. The second moisture-proof layer 34 is in contact with the sealing layer 20 and the adhesive layer 28.

The second moisture-proof layer 34 is provided between the sealing layer 20 and a resin case 26. The second moisture-proof layer 34 is provided along an inner wall surface of the resin case 26. The second moisture-proof layer 34 is in contact with the inner wall surface of the resin case 26.

The second moisture-proof layer 34 is provided between the sealing layer 20 and a base plate 10. The second moisture-proof layer 34 is in contact with the base plate 10 and the resin case 26.

The second moisture-proof layer 34 covers an insulating substrate 12. The second moisture-proof layer 34 covers a first MOSFET 14 and a second MOSFET 16. The second moisture-proof layer 34 covers a wire fixing layer 22. The second moisture-proof layer 34 is in contact with, for example, a first moisture-proof layer 24.

With the power semiconductor module 201 of the modification of the second embodiment, it is possible to further suppress the entry of moisture into an interface between the wire fixing layer 22 and the sealing layer 20. Therefore, for example, occurrence of a short circuit failure of the first MOSFET 14 is suppressed.

As described above, according to the second embodiment and the modification, it is possible to implement a semiconductor device capable of suppressing a connection failure of wiring and having high reliability.

### (Third Embodiment)

A semiconductor device according to a third embodiment is different from the semiconductor device according to the first embodiment in that the semiconductor device according to the third embodiment further includes a fifth resin layer in contact with a frame body and a base plate, the fifth resin layer containing a fifth resin having a moisture permeability lower than a moisture permeability of a first resin and a moisture permeability of a fourth resin, and a fourth resin layer is provided between a first resin layer and the fifth resin layer. Hereinafter, some descriptions of contents overlapping with the first embodiment may be omitted.

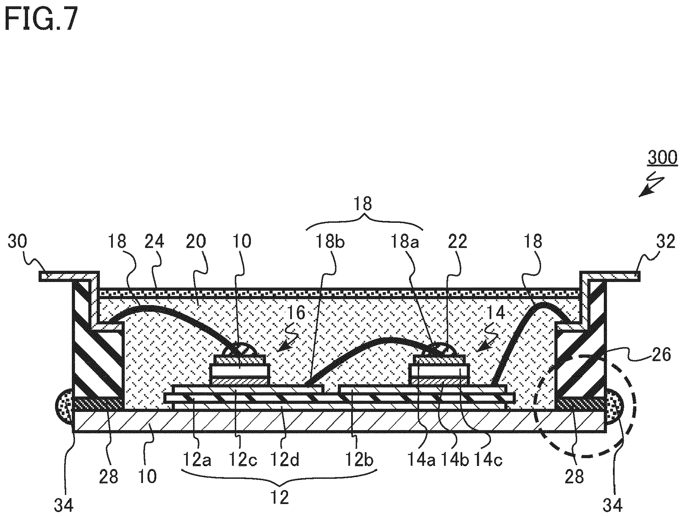

FIG. 7 is a schematic cross-sectional view of the semiconductor device according to the third embodiment. FIG. 7 is a diagram corresponding to FIG. 1A of the first embodiment.

The semiconductor device according to the third embodiment is a power semiconductor module 300.

The power semiconductor module 300 includes a base plate 10, an insulating substrate 12, a first MOSFET 14, a second MOSFET 16, a bonding wire 18, a sealing layer 20, a wire fixing layer 22, a first moisture-proof layer 24, a resin case 26, an adhesive layer 28, a first power terminal 30, a second power terminal 32, and a second moisture-proof layer 34. The insulating substrate 12 includes a ceramic layer 12a, a first surface metal layer 12b, a second surface metal layer 12c, and a back surface metal layer 12d. The first MOSFET 14 includes an upper electrode 14a, a lower electrode 14b, and a semiconductor layer 14c. The bonding wire 18 has a first end portion 18a and a second end portion 18b.

The first surface metal layer 12b is an example of a first metal layer. The second surface metal layer 12c is an example of a second metal layer. The first MOSFET 14 is an example of a semiconductor chip. The sealing layer 20 is an example of a first resin layer. The wire fixing layer 22 is an example of a second resin layer. The first moisture-proof layer 24 is an example of a third resin layer. The resin case 26 is an example of a frame body. The adhesive layer 28 is an example of a fourth resin layer. The second moisture-proof layer 34 is an example of a fifth resin layer.

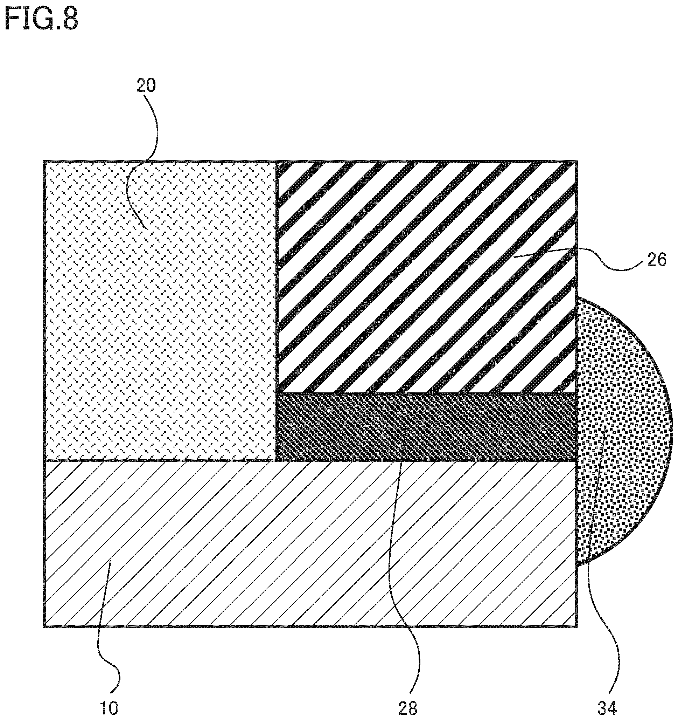

FIG. 8 is an enlarged schematic cross-sectional view of the semiconductor device according to the third embodiment. FIG. 8 is an enlarged view of a portion surrounded by a dotted line in FIG. 7. FIG. 8 is an enlarged view including the second moisture-proof layer 34.

The second moisture-proof layer 34 is in contact with the resin case 26 and the base plate 10. The second moisture-proof layer 34 is in contact with an outer wall surface of the resin case 26. The second moisture-proof layer 34 annularly surrounds the outer wall surface of the resin case 26.

The adhesive layer 28 is provided between the sealing layer 20 and the second moisture-proof layer 34. The adhesive layer 28 is in contact with the sealing layer 20 and the second moisture-proof layer 34. The second moisture-proof layer 34 annularly surrounds the adhesive layer 28.

The second moisture-proof layer 34 has a function of suppressing entry of moisture from the outside of the power semiconductor module 300. The second moisture-proof layer 34 has a function of suppressing entry of moisture through the adhesive layer 28 between the base plate 10 and the resin case 26.

The second moisture-proof layer 34 includes a second low-moisture-permeable resin. The second low-moisture-permeable resin is an example of a fifth resin. The second moisture-proof layer 34 is formed of, for example, the second low-moisture-permeable resin. The second low-moisture-permeable resin has a moisture permeability lower than a moisture permeability of a sealing resin contained in the sealing layer 20 and a moisture permeability of an adhesive resin contained in the adhesive layer 28.

The second low-moisture-permeable resin is, for example, synthetic rubber, a polyophyllene resin, para-xylene, or polyvinyl alcohol (PVA).

The second low-moisture-permeable resin may be the same material as or a different material from the first low-moisture-permeable resin.

With the power semiconductor module 300 of the third embodiment, entry of moisture into an interface between the wire fixing layer 22 and the sealing layer 20 can be further suppressed. Therefore, for example, occurrence of a short circuit failure of the first MOSFET 14 is suppressed.

### (Modification)

A semiconductor device according to a modification of the third embodiment is different from the semiconductor device according to the third embodiment in that a fifth resin layer is provided between a frame body and a base plate.

The semiconductor device according to the modification of the third embodiment is a power semiconductor module 301.

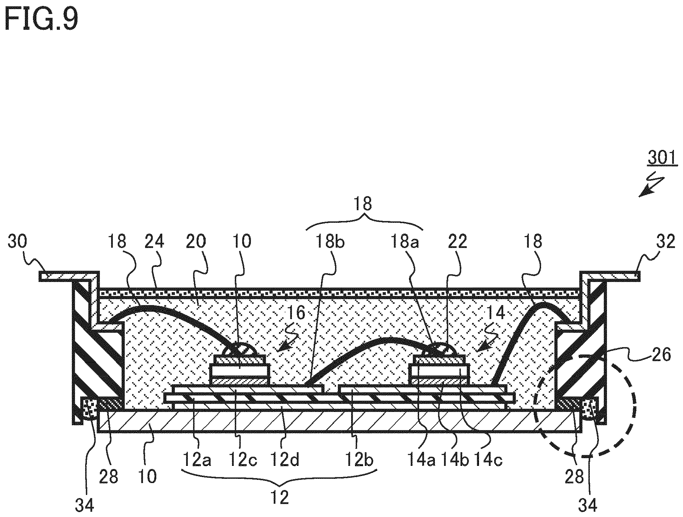

FIG. 9 is a schematic cross-sectional view of the semiconductor device according to the modification of the third embodiment. FIG. 9 is a diagram corresponding to FIG. 7 of the third embodiment.

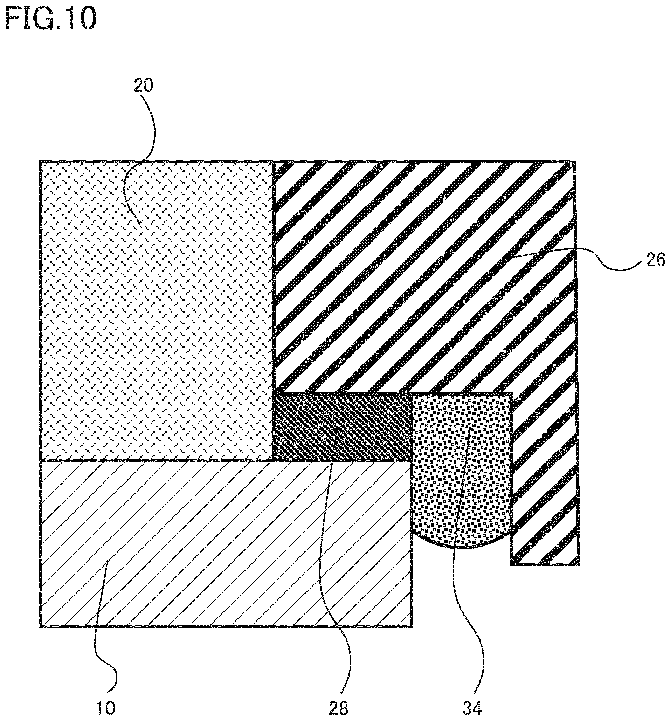

FIG. 10 is an enlarged schematic cross-sectional view of the semiconductor device according to the modification of the third embodiment. FIG. 10 is an enlarged view of a portion surrounded by a dotted line in FIG. 9. FIG. 10 is an enlarged view including a second moisture-proof layer 34.

The second moisture-proof layer 34 of the power semiconductor module 301 is provided between a resin case 26 and a base plate 10. The second moisture-proof layer 34 is in contact with the resin case 26 and the base plate 10.

An adhesive layer 28 is provided between a sealing layer 20 and the second moisture-proof layer 34. The adhesive layer 28 is in contact with the sealing layer 20 and the second moisture-proof layer 34. The second moisture-proof layer 34 annularly surrounds the adhesive layer 28.

The second moisture-proof layer 34 annularly surrounds the base plate 10. The resin case 26 annularly surrounds the second moisture-proof layer 34.

With the power semiconductor module 301 of the modification of the third embodiment, similarly to the power semiconductor module 300 according to the third embodiment, entry of moisture into an interface between a wire fixing layer 22 and the sealing layer 20 can be further suppressed. Therefore, for example, occurrence of a short circuit failure of a first MOSFET 14 is suppressed.

With the power semiconductor module 301 of the modification of the third embodiment, the second moisture-proof layer 34 is not provided on the outer periphery of the resin case 26. Therefore, for example, occurrence of an appearance defect caused by providing the second moisture-proof layer 34 is suppressed.

As described above, according to the third embodiment and the modification, it is possible to implement a semiconductor device capable of suppressing a connection failure and having high reliability.

In the first to third embodiments, a description has been given, as an example, as to a case in which a MOSFET is used as a semiconductor chip, but the semiconductor chip is not limited thereto. For example, other transistors and diodes such as an IGBT, a Schottky barrier diode (SBD), and a PIN diode can be applied. A combination of a transistor and a diode can also be applied.

In the first to third embodiments, a description has been given, as an example, as to a case in which the number of semiconductor chips is two, but the number of semiconductor chips may be one or three or more.

While certain embodiments have been described, these embodiments have been presented by way of example only, and are not intended to limit the scope of the inventions. Indeed, the semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (100,200,201,300,301) comprising:
a base plate (10);
an insulating substrate (12) provided on the base plate (10), the insulating substrate (12) having a first metal layer (12b) and a second metal layer (12c) on a surface thereof;
a semiconductor chip (14) provided on the first metal layer (12b), the semiconductor chip (14) including an upper electrode (14a), a lower electrode (14b) connected to the first metal layer (12b), and a semiconductor layer (12c) provided between the upper electrode (14a) and the lower electrode (14b);
a bonding wire (18) having a first end portion (18a) and a second end portion (18b), the first end portion (18a) being connected to the upper electrode (14a), and the second end portion (18b) being connected to the second metal layer (12c);
a first resin layer (20) configured to cover the insulating substrate (12), the semiconductor chip (14), and the bonding wire (18), the first resin layer (20) containing a first resin;
a second resin layer (22) configured to cover at least a part of a bonding portion (35) between the first end portion (18a) and the upper electrode (14a), the second resin layer (22) containing a second resin having a Young's modulus higher than a Young's modulus of the first resin;
a third resin layer (24) provided on the first resin layer (20) so as to be in contact with the first resin layer (20), the third resin layer (24) containing a third resin having a moisture permeability lower than a moisture permeability of the first resin; and
a frame body (26) configured to surround the insulating substrate (12), the first resin layer (20), and the third resin layer (24).

2. The semiconductor device (100,200,201,300,301) according to claim 1, wherein the Young's modulus of the second resin is equal to or more than 1000 MPa.

3. The semiconductor device (100,200,201,300,301) according to claim 1 or 2, wherein a glass transition temperature of the second resin is equal to or more than 250°C.

4. The semiconductor device (100,200,201,300,301) according to any one of claims 1 to 3, wherein an elongation rate of the third resin is equal to or more than an elongation rate of the first resin.

5. The semiconductor device (200,201) according to any one of claims 1 to 4, further comprising:
a fourth resin layer (28) provided between the base plate (10) and the frame body (26) and configured to bond the base plate (10) and the frame body (26), the fourth resin layer (28) containing a fourth resin; and
a fifth resin layer (34) provided between the first resin layer (20) and the fourth resin layer (28), the fifth resin layer (20) containing a fifth resin having a moisture permeability lower than the moisture permeability of the first resin and a moisture permeability of the fourth resin.

6. The semiconductor device (200,201) according to claim 5, wherein the fifth resin layer (34) is in contact with the first resin layer (20) and the fourth resin layer (28).

7. The semiconductor device (201) according to claim 6, wherein:
the fifth resin layer (34) is provided between the frame body (26) and the first resin layer (20); and
the fifth resin layer (34) covers at least a part of the insulating substrate (12).

8. The semiconductor device (201) according to claim 7, wherein the fifth resin layer (34) covers at least a part of the semiconductor chip (14).

9. The semiconductor device (300,301) according to any one of claims 1 to 4, further comprising:
a fourth resin layer (28) provided between the base plate (10) and the frame body (26) and configured to bond the base plate (10) and the frame body (26), the fourth resin layer (28) containing a fourth resin; and
a fifth resin layer (34) configured to be in contact with the frame body (26) and the base plate (10), the fifth resin layer (34) containing a fifth resin having a moisture permeability lower than the moisture permeability of the first resin and a moisture permeability of the fourth resin, wherein
the fourth resin layer (28) is provided between the first resin layer (20) and the fifth resin layer (34).

10. The semiconductor device (300,301) according to claim 9, wherein the fourth resin layer (28) is in contact with the first resin layer (20) and the fifth resin layer (34).
